# EUROPEAN PATENT APPLICATION

(11) **EP 4 318 133 A1**
(43) Date of publication of application: **07.02.2024**
(21) Application number: 22189102.1
(22) Date of filing: 05.08.2022
(51) Int. Cl.: G03F 7/20, B23K 26/00, H01J 37/30

(54) **SYSTEM, APPARATUS AND METHOD FOR SELECTIVE SURFACE TREATMENT**

(71) Applicant: ASML Netherlands B.V., 5500 AH Veldhoven (NL)
(72) Inventor: VAN DER VOORT, Dennis, Dominic, 5500 AH Veldhoven (NL)
(74) Representative: ASML Netherlands B.V.

(57) **Abstract**

Disclosed herein is a shielding system for use in a surface treatment process, comprising a first disk and a second disk. The first disk and second disk being arranged substantially parallel to each other. The first disk comprises a slit-shaped opening, the second disk comprises a plurality of openings; and the first and second disk are arranged to move with respect to each other around a common axis. Herewith, the slit can be positioned at one or more openings of the plurality of openings to form a passage through the shielding system.

## Description

### FIELD

The present invention relates to a system, an apparatus, and a method for selective surface-treatment of a supporting surface. Especially, the invention relates to a system for selective treatment of one or more burls on a surface arranged to support an object.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In a lithographic apparatus, the substrate is clamped onto a substrate support when transferring a pattern from the patterning device. The substrate support conventionally has a plurality of burls that support the substrate. The total area of the burls that contact the substrate is small compared to the total area of the substrate. Therefore, the chance that a contaminant particle randomly located on the surface of the substrate of the substrate support is trapped between a burl and the substrate is small. Also, in the manufacture of the substrate support, the tops of the burls can be made more accurately coplanar than a large surface can be made accurately flat.

In addition, the patterning device may be clamped to a mask support comprising a plurality of burls at its clamping surface.

Manufacturing tolerances, contamination and or wear of a burl-top surface may result in burl-height inaccuracies. Any inaccuracy in the height of a burl may cause an undesired local distortion of an object (e.g., a substrate or a patterning device) clamped to the support (e.g., the substate support or the mask support). Such a local distortion may be a cause of IC manufacturing inaccuracies. There is therefore a general need to provide a system and method suitable to improve surface characteristics of supporting surfaces.

### SUMMARY

According to a first aspect of the invention, there is provided a shielding system for use in a surface treatment process. The shielding system comprising: a main body for shielding a first area of the surface from an environment, e.g., a plasma, during a surface treatment process and an opening through the main body of the system for exposing a second area of the surface during the surface treatment process. The shielding system may be referred as a plasma shielding system.

According to a second aspect of the invention, there is provided shielding system, comprising a first disk and a second disk. The first disk and second disk are arranged parallel to each other with a common axis of rotation. The first disk comprises a slit-shaped opening and the second disk comprises a plurality of openings. The first and second disk are arranged to move with respect to each other around the common axis, whereby the slit can be positioned at one or more openings of the plurality of openings.

When provided in a system configured to perform a surface treatment process on a surface of an object, arranged between a radiation source, e.g., a plasma radiation source, and the surface of the object, a well-defined passage for the plasma can be defined for treating a selected area at a surface and shielding the rest of the surface.

According to a third aspect of the invention, there is provided a system configured to perform a plasma treatment process on part of a surface, the system comprising: a plasma source configured to generate a plasma environment, for example a plasma environment, and the arrangement according to the first and or the second aspect.

According to a fourth aspect of the invention, there is provided a method of performing a plasma treatment process on part of a surface. The method comprising: shielding a first area of the surface from a plasma environment and exposing a second area of the surface to the plasma environment, using the plasma shielding system according to the first and or the second aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 schematically depicts a substrate holder for use in a lithographic apparatus;
- Figure 3 schematically depicts a plurality of burls that are comprised by a substrate holder, and a removable shielding system according to an embodiment;
- Figures 4A and 4B schematically depict a shielding system according to an embodiment; and
- Figure 5A and 5B schematically depict a shielding system according to an embodiment.

### DETAILED DESCRIPTION

In the present document, the terms "radiation" and "beam" are used to encompass all types of electromagnetic radiation, including ultraviolet radiation (e.g., with a wavelength of 365, 248, 193, 157 or 126 nm) and EUV (extreme ultra-violet radiation, e.g., having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

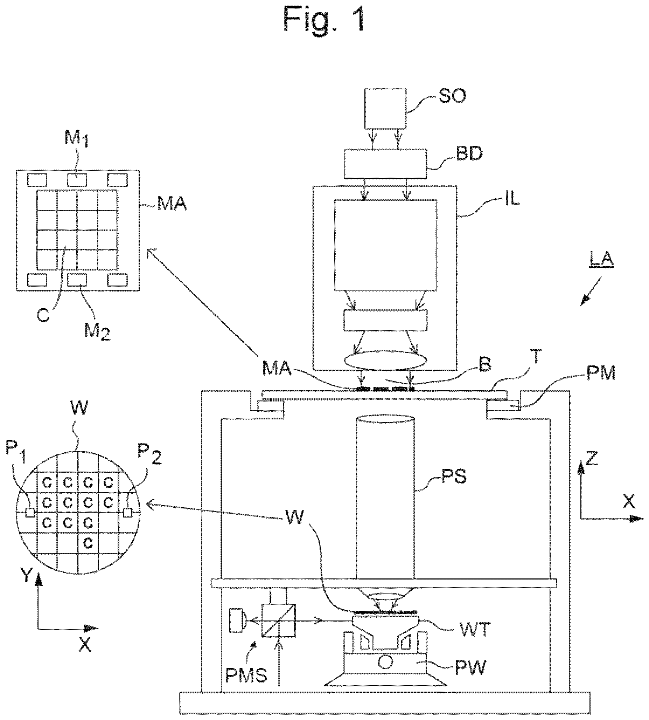

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g., mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

The substrate support WT, which may also be referred to as a substrate holder, is designed for accurate positioning of a substrate during exposure. The substrate holder usually comprises a solid body made of a rigid material and having similar in-plane XY dimensions to the production substrate W to be supported. The substrate-facing surface of the solid body is provided with a plurality of projections or protrusions that are referred to as burls. The distal surfaces of the burls conform to a substantially flat plane and support the substrate W. The burls provide several advantages: a contaminant particle on the substrate holder or on the substrate is likely to fall between burls and therefore does not cause a deformation of the substrate; it is easier to machine the burls so their ends conform to a plane than to make the surface of the solid body flat; and the heights of some of the burls can be reduced. Reducing the heights of some of the burls may improve the overall height profile of the burls and thereby improve how the substrate W is clamped.

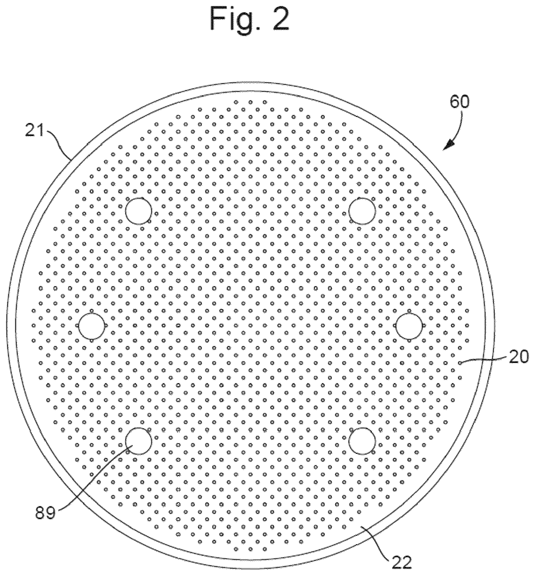

Figure 2 schematically depicts a substrate holder 60, that may be the substrate support WT, for use in a lithographic apparatus LA. The substrate holder 60 is for supporting the substrate W. The substrate holder 60 comprises a main body 21. The main body 21 has a main body surface 22. A plurality of burls 20 are provided projecting from the main body surface 22. The distal end surface of each burl 20 engages with the substrate W. The distal end surfaces of the burls 20 are substantially coplanar, i.e. the distal end surfaces of the burls 20 substantially conform to a support plane and support the substrate W. The main body 21 may be formed of a ceramic, for example SiC or SiSiC. The burls 20 may be formed of the same material as the main body 21, or may comprise a different material, for example, diamond-like carbon (DLC), diamond, boron nitride, boron carbide, tungsten carbide, aluminium oxide, sapphire, titanium nitride, titanium carbonitride, titanium aluminium nitride or titanium carbide.

The pitch of the burls 20 may be in the range from about 0.5 mm to 3 mm, e.g., about 1.5 mm. The pitch of the burls 20 is the distance between the centres of two adjacent burls 20. The total area of the distal end surfaces of the burls 20 may be in the range of from 1 % to 3% of the total area of the substrate holder 60. Burls 20 may be frusto-conical in shape, with burl side surfaces being slightly inclined. Alternatively, the burl side surfaces may be vertical or even overhanging. Burls 20 may be circular in plan view. Alternatively, burls 20 can also be formed in other shapes if desired.

A plurality of through-holes 89 may be formed in the main body 21. Through-holes 89 allow the e-pins to project through the substrate holder 60 to receive the substrate W. Through-holes 89 may also allow the space between the substrate W and the substrate holder 60 to be evacuated. Evacuation of the space between the substrate W and the substrate holder 60 can provide a clamping force, if the space above the substrate W is not also evacuated. The clamping force holds the substrate W in place. If the space above the substrate W is also evacuated, as would be the case in a lithographic apparatus using EUV radiation, electrodes can be provided on the substrate holder 60 to form an electrostatic clamp.

Other structures, for example to control gas flow and/or thermal conductivity between the substrate holder 60 and the substrate W, can be provided. The substrate holder 60 can be provided with electronic components. Electronic components may comprise heaters and sensors. Heaters and sensors may be used to control the temperature of the substrate holder 60 and substrate W.

The burls 20 of the substrate holder 60 wear during use, e.g., due to the repeated loading and unloading of substrates W. In addition, the burls may become contaminated, for example with particles or with thin material film, during use. Wear as well as contamination of the burls 20 leads to change of surface profile provided by the distal end surfaces of the burls 20.

Any inaccuracy in the height of a burl may cause an undesired local distortion of a substrate W clamped to the substrate holder 60. Such a local distortion may be a cause of manufacturing inaccuracies.

It is known for the manufacturing and/or maintenance of burls 20 to comprise cleaning and polishing processes, for example by means of a system and a method as disclosed in WO2018/224303, and ion beam figuring (IBF) processes.

A polishing process may be first performed.

A height profile of the distal end surfaces of the burls 20 may then be generated by measuring the height using a sensor. Such a height measurement may be done using any of a number of known techniques, for example using a non-contacting sensor, e.g., an optical sensor, or a contacting sensor. The height profile may be determined by, for example, optical interferometer measurements. A height profile map may be generated, which may be referred to as a hitmap, to indicate the burls or areas that require a surface treatment. The determined height profile may be relative to measurements of clamped substrates W of known thicknesses.

An IBF process may then be performed in dependence on the determined height profile. The IBF process uses a high energy ion beam, for example an Argon ion beam, to remove material from the burls. The IBF process may reduce the height variations in the burls, as determined by the height profile measurement.

A problem with the IBF process is that it is a wide area process. That is to say, the IBF process may be used to reduce the height of all of a plurality of burls 20 in a region of the substrate holder 60. The IBF process is not able to reduce the height of only a single one of the burls 20. Hence, burls and areas that do not require a surface treatment, may be affected by the IBF process. In addition, the IBF process has an impact on the roughness and surface properties of the burls 20 (those to be treated as well as those that should not be treated). The IBF process may result in burls 20 having a damaged or an amorphous layer that may increase the wear of the burls 20.

Embodiments provide a new technique for the surface treatment of an area, especially a treatment of a selected area . Embodiments use a plasma, for example an hydrogen plasma, to treat a surface. An opening in a shielding system may define the area of the surface that is treated by means of the plasma.

An exemplary application of embodiments is a technique for treatment of a surface of a burl 20 or a supporting surface 22. The technique may be used for reducing the height of one or more burls 20. Embodiments may use a plasma to reduce the height of one or more of the burls 20, without substantially impacting the surface topology on a nanometer scale or larger. In particular, embodiments include using a shield to control which burls the hydrogen plasma is applied to. The shield may allow the height of only a single one of the burls 20 to be reduced. Embodiments may use a plasma to treat an area of the supporting surface 22 between the burls 20, without substantially impacting the burls 20. This may be beneficial to remove contaminates on an area of the supporting surface 22 between the burls 20.

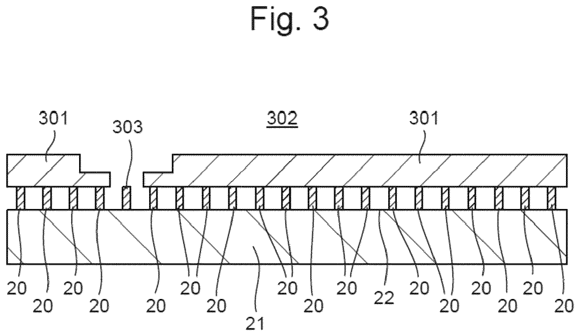

Embodiments for changing the height profile of one or more of a plurality of burls 20 are described in more detail below with reference to Figures 3, 4A, 4B, 5A and 5B.

Figure 3 schematically shows a cross-sectional view of a plurality of burls 20, 303 that are comprised by a substrate holder. The substrate holder may be the same as the above-described substrate holder 60/substrate support WT for use in a lithographic apparatus LA. The substrate holder is for supporting a substrate W. The substrate holder comprises a main body 21. The main body 21 has a main body surface 22. A plurality of burls 20, 303 project from the main body surface 22. Also shown in Figure 3 is a removable shield 301 according to an embodiment. The shield 301, or shielding system, is arranged to cover at least some, and preferably most, of the burls 20. The shield 301 may be made from the same material as a substrate W. The shield 301 according to embodiments is described in more detail later.

To provide a desired height profile of the burls 20, 303, a polishing process may first be performed. The polishing process may be performed when none the burls 20, 303 is covered by the shield 301. The polishing process may be according to the known techniques as used in wide area IBF processes.

The height profile of the distal end surfaces of the burls 20, 303 may then be determined according to the known techniques used in wide area IBF processes. These may include the above-described optical interferometer measurements and/or determination of a height profile relative to measurements of clamped substrates W of known thicknesses. In dependence on the height profile, a determination may be made to reduce the height of one or more of burls 20, 303.

Embodiments differ from known techniques by providing the shield 301 over burls 20 of the substrate holder. The shield 301 may have been selected, and/or configured, so that the shield 301 comprises an opening at the location of a single burl 303, or selective surface at the support 22, for which a surface treatment, e.g., a height reduction, is required. The shield 301 may cover the distal end surface of all of the plurality of burls 20 apart from the distal end surface of a single burl 303. The shield 301 therefore shields the distal ends of all of the burls 20 as well as the areas 22 between the burls from the environment 302 above the shield 301, apart from the single exposed burl 303.

When the opening is provided at a selected surface area between the burls 20, the shield 301 therefore shields the distal ends of all of the burls 20 as well as the areas 22 between the burls from the environment 302 above the shield 301, apart from the selected surface area.

The shield 301 may comprise plurality of coverable openings above the locations of the burls 20, 303. The shield 301 may be configured by covering all of the openings above burls 20 for which no height reduction is required, and not covering the opening above a burl 303, or burls 303, for which a surface treatment, e.g., a height reduction, is required.

A plasma treatment process may then be performed by providing a plasma environment above the shield 301. For example, a hydrogen plasma may be provided. A number of known techniques may be used to generate the plasma environment. These include the use of ion generators, electrodes, heat filaments and microwave generators. The plasma environment may be generated according to the techniques described in "Plasma generation and Plasma Sources", H. Conrads and M. Schmidt, Plasma Sources Science and Technology, vol. 9 (4) p. 441, 2000.

The object holder, e.g., the substrate support WT or the mask support T, may be moved into an apparatus for generating the plasma environment. The apparatus may comprise a plasma source, for example a hydrogen plasma source. The plasma source is preferably located directly above the centre of the object holder so that any object deformation caused by etching rate variations due to the location of the plasma source is bowl shaped and thereby easily correctable. During the plasma treatment process, the object holder, e.g., substrate support, may be grounded. The ion energies in the plasma treatment process are preferably at least 2 eV so that an appropriate etch rate is achieved. If the ion energies in plasma treatment process are too high, then the ions may damage the exposed structures. The ion energies in the plasma treatment process are preferably less than 15 eV, more preferably less than 10 eV, and even more preferably less than 6 eV.

A control unit, or controller, may be provided to set and to control the ion energy of the plasma. This may be an energy of a hydrogen plasma. In addition, the controller may be arranged to control a ratio between ions and radicals in the plasma. This may be a ration between hydrogen ions and hydrogen radicals in the plasma. Control of the energy and or the ratio is advantageous for an efficient treatment of surfaces.

In the plasma treatment process, a plasma radiation may etch the distal end of the single exposed burl 303. The plasma radiation may be used to etch away a definable amount of material. The etching process may reduce the height of the exposed burl 303 without causing any substantial damage to the exposed burl 303. The etching process may reduce the height of the exposed burl 303 at a rate of about 5 to 25 nm/hour. The rate of the etching process may depend on the applied gas or ion pressure and distance from the plasma source. The duration of the etching process may be used to control the applied treatment of the surface, and hence the height reduction of the burl 303. The exposed surfaces may be left uniform and clean. The etching process may be independent of the roughness of the etched surfaces, i.e., the etching process may be homogenous. All of the burls 20 that have their distal end surfaces covered by the shield 301 may be substantially unaffected by the plasma environment.

All of the processes may be automatically controlled by a processing system. In particular, the processing system may receive the height profile map of the surface of interest. The processing system may be controlled manually or may operate automatically to determine which areas and or burls require a selective surface treatment. Furthermore, the processing system may (automatically) configure a shield 301 based on the selected region, and automatically control the plasma treatment process to treat the selected region, e.g., burl 303.

Accordingly, embodiments allow the selected surface to be treated in a controlled manner. Especially, embodiments allow the height of a single burl 303 to be reduced in a controlled manner. By repeating the process with different burls 20 (or different selected areas), the heights of a plurality of burls 20 may be reduced. The burl height reductions may be made accurately and in dependence on the determined height profile of the burls. Embodiments thereby improve the height profile of the burls 20. The use of a plasma according to embodiments allows the height reduction of one or more burls without substantial impact of the surface topology on a nanometer scale or larger. This is an advantage over known IBF techniques in which the high energy sputtering causes surface sputtering.

Embodiments include other techniques for shielding, i.e., masking, burls 20 whilst leaving one or more of the burls 303 exposed for plasma treatment. A removable coating may alternatively, or additionally, be used to shield burls 20.

It will be appreciated by the skilled person, that the same plasma treatment using the shield as disclosed above may be applicable for selective surface treatment of a mask support T. The mask support T may comprise burls for supporting a patterning device MA.

The skilled person will appreciate that the shield 301 as disclosed above may be used in a selective surface treatment system and or process using radiation, wherein the radiation is provided as one of laser radiation, electron beam, and ion beam. Using laser radiation in combination with the shield 301 will allow selective surface treatment of an object by means of laser ablation. The laser radiation may be radiation with a wavelength in the spectral range of visible light and or (extreme) ultra-violet light. The wavelength may be chosen in dependence of the material deposited on the surface to be treated (e.g., contaminant material) or the base material of the surface, e.g., material composition of the burls 303.

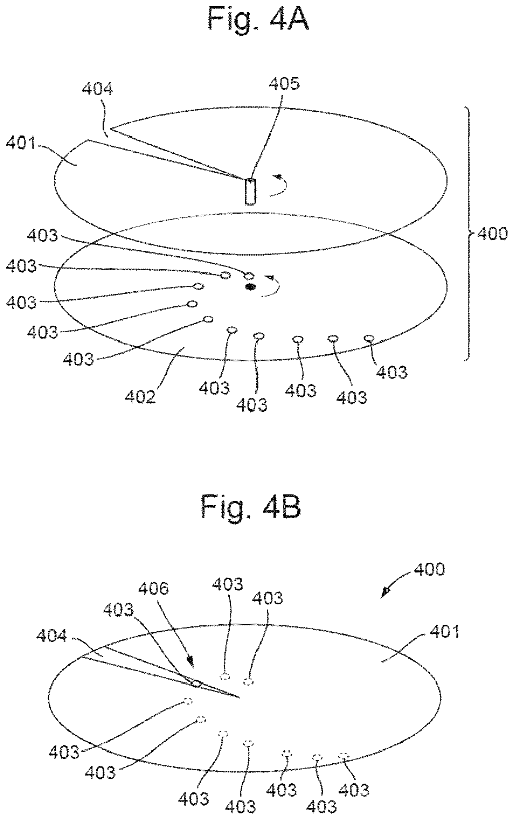

Figures 4A and 4B schematically show another shielding system 400 according to an embodiment. Figure 4A is an exploded view of the shielding system 400. Figure 4B shows the assembled shielding system 400.

The shielding system 400 comprises a first plate 401 and a second plate 402. The present embodiment is described with the first plate 401 being a first disc 401, and the second plate 402 being a second disc 402. However, embodiments also include the first and second plates 401, 402 having other shapes that discs. For example, the first and second plates 401, 402 may both be substantially rectangular.

The first disc 401 and second disc 402 are both substantially planar. The diameter of each of the first disc 401 and the second disc 402 may be substantially the same as each other and substantially the same as, or slightly larger than, diameter of the region of the substrate holder that is covered by burls.

The first disk 401 and or the second disk 402 may comprise mechanical means to strengthen the disk. Herewith, deformation of one or both disks may be prevented or limited.

The first disc 401 may comprise a slit opening 404, or first opening. In Figures 4A and 4B the slit opening 404 is shown as a wedge shaped opening. However, the slit opening 404 may alternatively be rectangular shaped, or have an irregular shape. The slit opening 404 may be provided from the center of the disk towards the edge of the disk. Alternatively, the slit opening does not continue till the edge, but a portion of the disk material closes the slit opening at the disk edge. Herewith, the disk forms closed loop at the periphery of the disk. This may be beneficial to avoid the plasma reaching a surface of an object that needs to be shielded during a surface treatment process. Especially, a surface area at an edge of the object underneath the shielding system.

The second disc 402 comprises a plurality of openings 403, or second openings. Each of the openings 403 may be circular, square, rectangular, or oval shaped. Preferably, each of the (second) opening 403 is circular in shape. Each of the openings 403 may be located at a different radial and axial position as seen from the mid-point of the second disc 402. The size of each opening 403 is appropriate for exposing only a single burl. Each opening 403 may have a different size. The openings 403 may be similar in size. The diameter of each opening 403 is preferably larger than the diameter of each burl 20. When the burls 20 have a diameter of about 200 µm and a pitch of about 1.5 mm, the diameter of each opening 403 may be about 200 µm to 1300 µm, and preferably about 400 µm to 1100 µm. When the burls 20 have a diameter of about 350 µm and a pitch of 2.5 mm, the diameter of each opening 403 may be about 350 µm to 2150 µm, and preferably about 550 µm to 1950 µm.

The plurality of openings 403 (or second openings) may be provided to the second disk 402 along a spiral arrangement. The second disk 402 may be provided with openings 403 arranged along one or more spirals. The openings 403 may be arranged pursuant to a phyllotactic spiral.

When the shielding system 400 is assembled, as shown in Figure 4B, the first disc 401 may be provided close to, or in contact with, the second disc 402. The plane of the first disc 401 may be parallel to the plane of the second disc 402 with the spacing between the first disc 401 and the second disc 402 less than 100 µm. The midpoints of the first disc 401 and the second disc 402 may be aligned with each other in a line orthogonal to the planes of the first disc 401 and the second disc 402. When the shielding system 400 is provided over burls 20 of a substrate holder, the second disc 402 is preferably closer to the substrate holder than the first disc 401.

The thickness of each of the first disc 401 and the second disc 402 may be less than 2 mm. The shielding system 400 is preferably as thin as possible. The thickness of the shielding system 400 is preferably less than two times the diameter of one of the (second) openings 403, more preferably less than the diameter of one of the openings 403, and even more preferably less than half the diameter of one of the openings 403.

The shielding system 400 may comprise a revolute joint 405 for supporting the relative axial rotation of the first disc 401 and the second disc 402. The relative axial rotation of the first disc 401 and the second disc 402 may be controlled by the operation of a motor. The motor may be arranged to rotate the first disc 401 with the second disc 402 held stationary, rotate the second disc 401 with the first disc 402 held stationary, or rotate both the first disc 401 and the second disc 402 in opposite directions. The motor may also be arranged to axially rotate the entire shielding system 400 with no relative axial rotation occurring between the first disc 401 and the second disc 402. The motor may be provided either above the shielding system 400 or to the side of the shielding system 400. The use of a revolute joint 405 is optional and, in particular when the motor is provided to the side of the shielding system 400, the axis of rotation may not be fixed. The relative movements of the first and second discs 401, 402 may also be only linear movements without rotational movements occurring.

When the first disc 401 and the second disc 402 are axially rotated relative to each other, the slit opening 404 (first opening) of the first disc 401 may be moved over any one of the openings 403 (second opening). The slit opening 404 may be shaped so that the first disc 401 may cover all of the openings 403 apart from a single opening 406 that the slit opening 404 is over. At all locations along its length, the width of the slit opening 404 may be less than the separation between adjacent openings 403, so that there is no position of the slit opening 404 that causes more than one opening 403 to be exposed.

Accordingly, only a single opening 406 of the plurality of openings 403 may provide a passage through the shielding system 400. The passage through the shielding system 400 is defined by which one of the openings 403 is covered by the slit opening 404. By rotating the first disc 401 relative to the second disc 402, a different one of the openings 403 may define the passage through the shielding system 400.

The position of the slit in the first disk 401 and the orientation of the second disk 402 (herewith arranging one of the plurality of openings 403) may be set and controlled by a control unit, e.g., a controller. The controller may determine the position and orientation of both disks based on a height profile map or hitmap.

All of the burls 20 may be arranged on the substrate holder in a plurality of concentric circles with different radii. The radial position of each burl opening in the second disc 402 may arranged so that so that, when the shielding system 400 is provided above the burls 20, there is an opening 403 that may be aligned with each burl by only an axial rotation of the second disc 402. Accordingly, a rotation of the first disc 401 relative to the second disc 402, as well as a rotation of the shielding system 400, may be used to provide a passage through the shielding system 400 above any of the burls 20 on the substrate holder (apart from the central burl 20). The shielding system 400 may therefore be configured so that a specific one of the burls 20 is exposed.

If the substrate holder comprises a centrally located burl 20, then to expose the centrally located burl 20 the shielding system 400 may be moved horizontally so that the passage through it is aligned with the centrally located burl 20. Alternatively, a separate shield may be used for exposing the centrally located burl 20.

The shielding system 400 may be used in the above-described plasma treatment process according to embodiments. During the surface treatment process, e.g., plasma treatment process, both the first disc 401 and the second disc 402 may be grounded. Preferably, the object to be treated, e.g., substrate support or mask support, is grounded during the surface treatment process.

By controlling the relative rotation of the first disc 401 and second disc 402, and/or the overall rotation of the shielding system 400, the shielding system 400 may be reconfigured during the plasma treatment process. This allows more than one of the burls 20, or a selected area between the burls, to be exposed during the same plasma treatment process.

The shielding system 400 may be arranged to sit on the burls 20 during the plasma treatment process. The shielding system 400 may be lifted, so that it is not sitting on the burls 20, during the rotations for reconfiguring the shielding system 400 for changing the exposed burl 303 to avoid damaging the burls and or the shielding system 400.

Alternatively, the shielding system 400 may be held slightly above the burls 20 during the plasma treatment process. The space between the shielding system 400 and the burls 20 should be large enough to avoid the problem of any sagging of the shielding system 400 causing a collision between the shielding system 400 and the burls 20. Mechanical means may be provided to one of or both of the disks to prevent sagging. However, the space between the shielding system 400 and the burls 20 is preferably about as small as possible after the tolerance provided for sagging. The space between the shielding system 400 and the burls 20 is preferably smaller than the Debye length of the plasma, which is about 100 µm.

The determination of the height profile, the configuration of the shielding system 400, and the operations of the entire plasma treatment process may be automatically controlled by one or more processing systems. In particular, a controller may receive data on one or more burls 20, or areas at the supporting surface, that should be treated and automatically configure the shielding system 400 in dependence on the received data.

Accordingly, embodiments provide a technique for improving the height profile of burls 20. The height of each burl 20 may be changed individually. The height of each burl may also be changed accurately. The exposure time by a plasma source may be controlled with millisecond accuracy. With the plasma process providing an etch rate of about 5 to 25 nm/hour, the reduction in the height of a burl 20 can be controlled down to the picometer level.

The design of a substrate holder, and in particular the typical height of each burl 20 on the substrate holder, varies between the processes the substrate holder is to be used for. For example, the typical burl height for a substrate holder that is designed for use in an lithographic process may be in a range of about 10 µm to about 200 µm. For burls with a height of about 10µm, embodiments may be used to reduce their height by less than about 1nm, or more than 1nm if this is required. For burls with a height of about 200 µm, embodiments may be used to reduce their height by up to about 10 nm, or more than 10 nm if this is required.

Embodiments include a number of modifications a variations to the above-described techniques.

Embodiments include the use of shields that simultaneous expose more than one burl 20. For example, the shielding system may comprise a single opening that is large enough to expose a plurality of burls 20. The heights of a plurality of burls 20 may be simultaneously reduced. A different shielding system may then be used to reduce the heights of one or more of the burls 20 individually if required. This may be faster process than only individually reducing the heights of the burls 20.

Embodiments also include the use of shielding systems that comprise more than one opening for simultaneously exposing more than one burl 20.

It should be noted that although the distal end surfaces of the burls 20 may substantially conform to a plane, the preferred height profile of the burls 20 may be the same as the profile of the substrate W that is clamped to the substrate holder. Accordingly, if a substrate has a slight bowl deformation, then the preferred profile provided by the distal end surfaces of the burls 20 would have a slight convex form so that the end of each burl is flush with the surface of the substrate.

Embodiments include the height profile provided by the distal end surfaces of the burls 20 being changed so that it better fits the general shape of substrates W that are clamped to the substrate holder 60. The height profile provided by the distal end surfaces of the burls 20 may not be flat.

Embodiments are not restricted to the specific application of reducing the height of burls. Embodiments more generally include the use a plasma to treat a surface, with an opening in a shielding system defining the area of the surface that is treated.

The shielding system according to embodiments is not restricted to being a disc. Embodiments include the use of any shape of shield so long as the shield defines a first area of a surface that is not exposed to the plasma environment, and at least one opening in the shield defines second area of the surface that is exposed to the plasma environment.

The skilled person will appreciate that the shielding system 400 as disclosed above may be used in a selective surface treatment system and or process using radiation, wherein the radiation is provided as one of laser radiation, electron beam, and ion beam. Using laser radiation in combination with the shielding system 400 will allow selective surface treatment of an object by means of laser ablation. The laser radiation may be radiation with a wavelength in the spectral range of visible light and or (extreme) ultra-violet light. The wavelength may be chosen in dependence of the material deposited on the surface to be treated (e.g., contaminant material) or the base material of the surface, e.g., material composition of the burls.

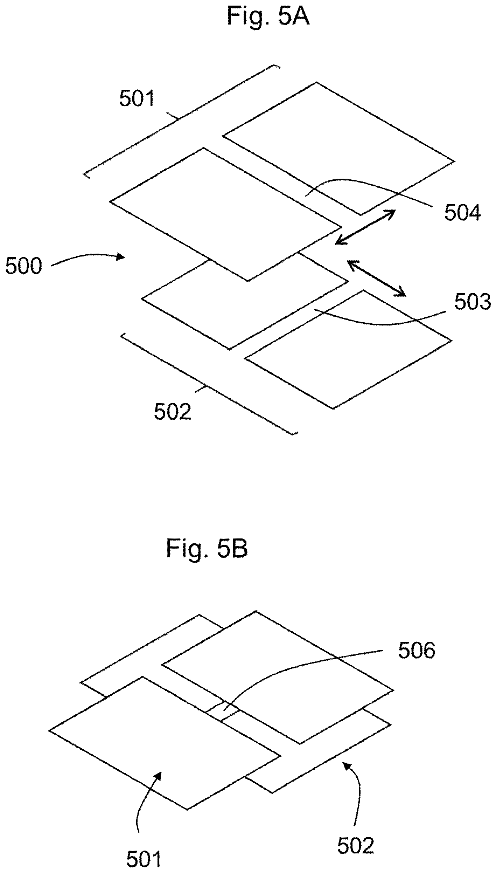

Embodiments include a shielding system 500 that comprises a plurality of moveable plates, or blades. For example, the shielding system 500 may comprise a first layer that has a first pair of substantially rectangular plates 501, as schematically illustrated in Figure 5A and 5B. Figure 5A depicts an exploded view of the shielding system 500. Figure 5B depicts an assembled view of the shielding system 500. The first pair of plates 501 may be separated from each other so that there is a first linear opening 504, e.g., a first slit opening, between them. The shielding system 500 may also comprise a second layer that has a second pair of substantially rectangular plates 502. The second pair of plates 502 may be separated from each other so that there is a second linear opening 503, e.g., a second slit opening, between them. The first and second pairs of plates 501, 502 may be oriented so that the first and second linear openings 504, 503 (or slit openings) are substantially orthogonal to each other. There will then be a rectangular, or square, opening 506 through the shield at the location where the first and second linear openings overlap each other. The size and location of the opening 506 may be varied by changing the locations and separations of the first and second pairs of plates 501, 502.

At the opening 506, an auxiliary element may be provided that is arranged to move along with the opening. The auxiliary element may have a central circular opening, such that the passage through the shielding system 500 matches with a base-diameter of a burl. When cylindrical shaped burls are treated according to an aspect of the invention, it is preferred that the passage 506 in the shielding system 500 is similar is shape and dimension. Herewith, unintended treatment of an area surrounding the burl of interest is minimized or may be prevented.

Size of the first and second pair of plates 501, 502 is such that they shield at least partly, preferably completely, the surface of the object that is subject for the selective surface treatment by means of a plasma. Both the first and second 501, 502 are similar in size as a substate support WT or a mask support T as used in a lithographic apparatus.

The shielding device 500 comprising the first and the second pair of plates may be preferred for surface treatment of an object comprising burls arranged in non-concentric circles, for example, arranged in a linear configuration.

The position of the first slit opening 504 and the second slit opening 503, herewith arranging the opening or passage 506, may be set and controlled by a control unit, e.g., a controller. The controller may determine the position of both slit openings based on a height profile map or hitmap.

During surface treatment process, for example during a plasma treatment process, both the first pair of plates 501 and the second pair of plates 502 may be grounded. Preferably, the object to be treated, e.g., substrate support or mask support, is grounded during the surface treatment process.

According to an embodiment, an apparatus is provided for conditioning a component of a lithography apparatus. The apparatus comprises a housing configured to contain a plasma, e.g., a hydrogen plasma, wherein the plasma is provided by a plasma generator. Supporting means are provided to support an object to be treated with the plasma. A shielding system 301, 400, 500 is arranged between the plasma source and the supporting means to shield at least a portion of a surface of the object, wherein the apparatus is configured to control at least one of the ratio of ions, e.g., hydrogen ions, to radicals, e.g., hydrogen radicals, in the plasma, the energy of the plasma, and the position of the passage or opening through the shielding system for selective surface treatment of the object.

Embodiments include moving the substrate support to a specific apparatus for performing the plasma treatment process. Alternatively, the plasma treatment process may be performed in the same apparatus as that used for lithography or metrology processes (in-situ). The apparatus may already include a plasma source for generating a plasma environment, e.g., a hydrogen plasma, with an appropriate ion energy. Alternatively, a new plasma source may be included in the apparatus.

Embodiments are not restricted to the surface treatment of a substrate holder. Embodiments include treating the surface of any structure. The applied surface treatment is also not required to change a surface profile and may, for example, only clean the surface. Embodiments in particular include the surface treatment of a mask / reticle / patterning device support structure, which may also comprise burls. Embodiments may be used for cleaning and/or changing the profile of the burls.

Embodiments are not restricted to the surface treatment by means of a plasma, for example hydrogen plasma. Embodiments include treating the surface by means of radiation, for example laser radiation, electron beams, or ion beams. For example, when using laser radiation, e.g., high energy photons or high beam intensities, the skilled person may position the shielding system to select a specific area on a surface for treatment using the laser radiation. By means of the laser radiation, laser ablation may be initiated at the selected surface area or region. Herewith, the top surface at, for example, a burl may be treated. That is, the height of the burl can be reduced by means of the laser induced surface treatment (e.g., laser ablation) and or contamination at the burl is removed.

By means of the aforementioned shielding system, a precise selection of the area or region that requires treatment by radiation (plasma radiation, laser radiation, electron beam, or ion beam) can be achieved.

Embodiments include the following numbered clauses:
1. A shield for use in a plasma treatment process of a surface, the shield comprising: a main body for shielding a first area of the surface from the plasma treatment process; and an opening through the main body of the shield for exposing a second area of the surface during the plasma treatment process.
2. The shield according to clause 1, wherein: the plasma treatment process is for reducing the height of at least one burl; the main body of the shield is arranged to shield a plurality of burls in the first area from the plasma treatment process; and
   the opening through the main body of the shield is arranged to expose at least one burl in the second area during the plasma treatment process.
3. The shield according to clause 2, wherein the opening is configured to expose only a single one of a plurality of burls.
4. The shield according to clause 2 or 3, wherein the shield comprises: a first plate with a slit opening; and a second plate with a plurality of burl openings; wherein: the first plate and second plate are rotatable relative to each other; the opening through the shield is one of the burl openings; and the burl opening that provides the opening through the shield is dependent on the relative rotational position of the slit opening and the burl openings.
5. An arrangement comprising: a structure with a surface; and a shield for covering at least some of the surface; wherein the shield is according to any of clauses 1 to 4.
6. The arrangement according to clause 5, wherein: the structure comprises a plurality of burls; and the shield is arranged to cover at least some of the burls.
7. The arrangement according to clause 6, wherein the structure is a substrate holder.
8. A system configured to perform a plasma treatment process on part of a surface, the system comprising: a plasma source configured to generate a plasma environment; and the arrangement according to any of clauses 5 to 7.
9. The system according to clause 8, wherein the system is configured to perform a plasma treatment process on one or more of a plurality of burls.
10. The system according to clause 8 or 9, wherein the plasma source is configured to generate ions with energies that are preferably at least 2 eV, and preferably less than 15 eV, and more preferably less than 10 eV, and even more preferably less than 6 eV.
11. The system according to any of clauses 8 to 10, wherein the system is further configured to perform a lithography process and/or a metrology process.
12. A method of performing a plasma treatment process on part of a surface, the method comprising: shielding a first area of the surface from a plasma environment; and exposing a second area of the surface to the plasma environment.
13. The method according to clause 12, wherein: the surface comprises a plurality of burls;
   the plasma treatment process is for reducing the height of at least one burl; a plurality of burls in the first area are shielded from the plasma treatment process; and at least one burl in the second area is exposed during the plasma treatment process.
14. The method according to clause 13, further comprising: determining the height profile of the plurality of burls; and performing the shielding in dependence on height profile.
15. The method according to clause 13 or 14, wherein the shielding leaves only one exposed burl.
16. The method according to any of clauses 13 to 15, further comprising: changing the exposed burls during the exposure process by reconfiguring the shielding of the plurality of burls during the exposure process; and/or repeating the exposure process with different shielding configurations so as to change the exposed burls in each exposure process.
17. The shield according to any of clauses 1 to 4 or the system according to any of clauses 8 to 11 or the method according to any of clauses 12 to 16 wherein the plasma treatment process is a hydrogen plasma treatment process.
18. A shielding system for use in a surface treatment process, comprising a first disk and a second disk;
   the first disk and second disk being arranged substantially parallel to each other; the first disk having a slit-shaped opening; the second disk comprising a plurality of openings; and
   wherein the first and second disk are arranged to move with respect to each other around a common axis, whereby the slit can be positioned at one or more openings of the plurality of openings to form a passage through the shielding system.
19. The shielding system according to clause 18, wherein the passage is configured to expose only a selected area on a surface of an object subjected to a surface treatment.
20. The shielding system according to clause 18 or 19, wherein the passage is configured to expose only one of a plurality of burls comprised on a surface of an object subjected to the surface treatment.
21. The shielding system according to any of clauses 18 to 20, wherein the plurality of openings is arranged at the second disk along one or more spiral arrangements.
22. A shielding system for use in a surface treatment process, comprising a first layer and a second layer, the first and second layer being arranged substantially parallel to each other;
   the first layer comprising a first pair of plates, providing a first slit opening between the first pair of plates;
   the second layer comprising a second pair of plates, providing a second slit opening between the second pair of plates; and wherein the first slit opening and the second slit opening are substantially orthogonal to each other, and providing an opening through the shield depending on the relative positions of the first and second slit openings.
23. The shielding system according to any of clauses 18 to 22, wherein the shielding system is arranged to shield a first area of an object surface from a radiation and to expose a second area of the object surface to the radiation via the passage in the shielding system during the surface treatment process.
24. The shielding system according to clause 23, wherein the radiation is a plasma, a laser radiation, an electron beam, or an ion beam.
25. The shielding system according to any of clauses 18 to 24, wherein the first disk and the second disk or the first layer and the second layer are grounded during the surface treatment process.
26. An apparatus for conditioning a component of a lithography apparatus, comprising a housing configured to contain a plasma; a plasma generator to provide the plasma;
   supporting means provided to support the component to be treated with the plasma; a shielding system according to any of clauses 18 to 25 arranged between the plasma source and the supporting means to shield at least a portion of a surface of the component; and
   wherein the apparatus is configured to control at least one of a ratio of ions to radicals in the plasma, an energy of the plasma, and a position of the opening through the shielding system for selective surface treatment of the component.
27. A method of performing a surface treatment process on part of a surface, the method comprising:
   shielding a first area of the surface from a radiation; and exposing a second area of the surface to the radiation to perform selective surface treatment.
28. The method of clause 27, wherein the radiation is a plasma, a laser radiation, an electron beam, or an ion beam.
29. The method according to clause 27 or 28, wherein: the surface comprises a plurality of burls;
   the surface treatment process is for surface treatment of at least one burl; a plurality of burls in the first area are shielded from the surface treatment process; and at least one burl in the second area is exposed during the surface treatment process.
30. The method according to any of clauses 27 to 29, further comprising: determining the height profile of the plurality of burls; and performing the shielding in dependence on height profile.
31. The method according to any of clauses 27 to 30, wherein the shielding system leaves only one exposed burl.
32. The method according to any of clauses 27 to 31, further comprising: changing the exposed burls during the exposure process by reconfiguring the shielding system of the plurality of burls during the exposure process; and/or repeating the exposure process with different shielding configurations so as to change the exposed burls in each exposure process.
33. The shielding system according to any of clauses 18 to 25, wherein the position of the slit in the first disk and the orientation of the second disk or the first slit opening and the second slit opening are set and controlled by a controller.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A shielding system for use in a surface treatment process of an object, comprising a first disk and a second disk;
the first disk and second disk being arranged substantially parallel to each other;
the first disk having a slit-shaped opening;
the second disk comprising a plurality of openings; and
wherein the first and second disk are arranged to move with respect to each other around a common axis, whereby the slit can be positioned at one or more openings of the plurality of openings to form a passage through the shielding system.

2. The shielding system according to claim 1, wherein the passage is configured to expose only a selected area on a surface of the object subjected to the surface treatment process.

3. The shielding system according to claim 1 or 2, wherein the passage is configured to expose only one of a plurality of burls comprised on a surface of the object subjected to the surface treatment.

4. The shielding system according to any of claim 1 to 3, wherein the plurality of openings is arranged at the second disk along one or more spiral arrangements.

5. A shielding system for use in a surface treatment process of an object, comprising:
a first layer and a second layer, the first and second layer being arranged substantially parallel to each other;
the first layer comprising a first pair of plates, providing a first slit opening between the first pair of plates;
the second layer comprising a second pair of plates, providing a second slit opening between the second pair of plates; and
wherein the first slit opening and the second slit opening are substantially orthogonal to each other, and providing an opening through the shield depending on the relative positions of the first and second slit openings.

6. The shielding system according to any of claims 1 to 5, wherein the shielding system is arranged to shield a first area of an object surface from a radiation and to expose a second area of the object surface to the radiation via the passage in the shielding system during the surface treatment process.

7. The shielding system according to claim 6, wherein the radiation is a plasma, a laser radiation, an electron beam, or an ion beam.

8. The shielding system according to any of claim 1 to 7, wherein the first disk and the second disk or the first layer and the second layer are grounded during the surface treatment process.

9. An apparatus for conditioning a component of a lithography apparatus, comprising a housing configured to contain a plasma;
a plasma generator to provide the plasma;
supporting means provided to support the component to be treated with the plasma;
a shielding system according to any of claims 1 to 8 arranged between the plasma source and the supporting means to shield at least a portion of a surface of the component; and
wherein the apparatus is configured to control at least one of a ratio of ions to radicals in the plasma, an energy of the plasma, and a position of the opening through the shielding system for selective surface treatment of the component.

10. A method of performing a surface treatment process on a selected part of a surface of an object, the method comprising:
shielding a first area of the surface from a radiation; and
exposing a second area of the surface to the radiation to perform selective surface treatment.

11. The method of claim 10, wherein the radiation is a plasma radiation, a laser radiation, an electron beam, or an ion beam.

12. The method according to claim 10 or 11, wherein:
the surface comprises a plurality of burls;
the surface treatment process is for surface treatment of at least one burl;
a plurality of burls in the first area are shielded from the surface treatment process; and at least one burl in the second area is exposed during the surface treatment process.

13. The method according to any of claims 10 to 12, further comprising:
determining the height profile of the plurality of burls; and
performing the shielding in dependence on a height profile map.

14. The method according to any of claims 10 to 13, wherein the shielding system leaves only one exposed burl.

15. The method according to any of claims 10 to 14, further comprising:
changing the exposed burls during the exposure process by reconfiguring the shielding system of the plurality of burls during the exposure process; and/or
repeating the exposure process with different shielding configurations so as to change the exposed burls in each exposure process.
